Europäisches Patentamt

European Patent Office

Office européen des brevets

(11) Publication number: 0 388 312 A2

## (12) EUROPEAN PATENT APPLICATION

(21) Application number: 90400717.6

(22) Date of filing: 16.03.90

(51) Int. Cl.5: H01L 23/12, H01L 23/495

(30) Priority: 17.03.89 JP 63780/89

(43) Date of publication of application:
19.09.90 Bulletin 90/38

(84) Designated Contracting States:
DE FR GB IT NL

(71) Applicant: FURUKAWA DENKI KOGYO
KABUSHIKI KAISHA
6-1 Marunouchi 2-chome
Chiyoda-ku Tokyo(JP)

Applicant: SEIKO EPSON CORPORATION
4-1, Nishishinjuku 2-chome
Shinjuku-ku Tokyo(JP)

(72) Inventor: Ohtani, Kenichi, c/o Furukawa Denki
Kogyo K.K.
Yokohama Kenkyusho, 2-4-3, Okano, Nishi-ku
Yokohama-shi, Kanagawa(JP)
Inventor: Kamimura, Masaru, c/o Seiko Epson
Corporation
3-5, Owa 3-chome
Suwa-shi, Nagano(JP)

(74) Representative: Schrimpf, Robert et al
Cabinet Regimbeau 26, Avenue Kléber
F-75116 Paris(FR)

(54) Chip carrier with improved flexing characteristic.

(57) A flexible film chip carrier including a plurality of groups of metal wires (3) formed on the surface of an electrically insulating flexible film member (2). The flexible film member is formed with a plurality of predetermined flexion parts in portions thereof which are in superposition relation with the metal wires, and the flexible film member is partly or wholly reduced in thickness in areas thereof each containing one of the predetermined flexion parts and its surroundings as compared with the remaining portion thereof. Each of the thin-section parts is in the form of a slit along the predetermined flexion part and the chip carrier is bendable at these thin-section parts.

FIG.1

## CHIP CARRIER WITH IMPROVED FLEXING CHARACTERISTIC

### BACKGROUND OF THE INVENTION

#### 1. Field of the Invention

The present invention relates to a chip carrier which is used for connecting semiconductor chips such as ICs or LSIs to lead frames or circuit boards.

#### 2. Description of the Prior Art

It has been known in the art to use for example a film chip carrier of a tape form or patch type for connecting semiconductor chips of high level integration to the connecting terminals of lead frames or circuit boards, for example.

While such chip carrier has not only a function of support semiconductor chips but also a function of bringing out connecting terminals for external circuitry or the like from the connecting pads of each semiconductor chip, it has recently become the general practice to provide the chip carrier itself with a function as a circuit board for a signal processing circuit. However, such added function of the chip carrier inevitably increases the density of the wiring pattern formed in this portion.

Also, with this type of chip carrier, there are many instances where the metal wires of the chip carrier must be bent for connection depending on the positional relation between objects to be incorporated such as in the case of interconnecting a liquid crystal display device and a circuit board thereof and it has been frequently desired to provide the base film of the chip carrier and the metal wires on the base film with such a low bending rigidity that they can be bent easily.

As a result, in the case of a chip carrier of a three-layer structure in which a metal foil forming metal wires and a flexible film member are laminated through an adhesive bond layer, there are many instances where the demand for the above-mentioned flexing characteristic cannot be met satisfactorily. Thus, where the metal wires must be bend during the use of the chip carrier, there are many instances where the chip carrier used is of a two-layer structure including no adhesive bond between the metal foil and the flexible film member.

However, even in the case of the chip carrier of the two-layer structure, if the pitch of the metal wires is reduced to less than about 200μm thus increasing the wiring density, the resulting increase in the bending rigidity of the chip carrier in the bending direction of the metal wires presents a problem.

Then, in order to decrease the bonding rigidity of the chip carrier, there are conceived a method of thinning the metal foil constituting the metal wires and a method of thinning the flexible film serving as the base of the metal foil. However, in the case of the former method, a situation arises where the current capacity of the metal wires is decreased and the strength of the metal wires is decreased in the connecting parts (hereinafter referred to as inner leads) to a semiconductor chip or the like to be mounted and outer connecting parts (hereinafter referred to as outer leads) to a lead frame or circuit board, thereby making it impossible to fit in practical use. Also, in the case of the latter method, if the flexible film is reduced in thickness to less than about 10 to 25μm, the tensile strength of the film member is decreased so that in the case of a tape carrier which is fed by the sprockets, there is the danger of the tape failing to withstand the tension during the tape feeding.

### SUMMARY OF THE INVENTION

It is the primary object of the present invention to provide a chip carrier which is provided with improved flexing characteristic without deteriorating the previously mentioned various functions required for its metal wires and flexible film member.

In accordance with a basic form of the present invention, a chip carrier includes a plurality of groups of metal wires formed on the surface of an electrically insulating flexible film member and a plurality of predetermined flexion parts are formed in the portions where the metal wires and the film member lie one upon other, particularly the flexible film member is reduced in thickness partly or wholly in the areas thereof containing the predetermined flexion parts as compared with the remaining portion thereof.

Thus, in accordance with the chip carrier of the present invention, due to the fact that the flexible film member is locally reduced in thickness in the portions where the metal wires are to be bent, there is no need to reduce the thickness of the metal wires so as to improve the flexing properties of the metal wires themselves.

Also, the strength of the chip carrier itself is ensured by the remaining portion which is not reduced in thickness so that even if the chip carrier is composed for example of a tape carrier, there is no danger of the flexible film member being ruptured by the tension during the tape feeding.

Such thin-section part may be formed in slit-like form at one or more places along the predetermined flexion parts of the flexible film member. The thickness of the thin-section parts should preferably be not greater than 1/2 of the flexible film thickness of the remaining portion from the flexing characteristic point of view and also the lower limit should preferably be not less than 5μm from the tensile strength point of view. It is to be noted that the shape and width of the slit-like parts forming the thin- section parts can be suitably selected depending on the form into which the chip carrier is bent.

Also, the thin-section parts are not limited to the slit-like form so that it is possible to reduce only the thickness of the flexible film member in the portions just below the metal wires placed on the predetermined flexion parts in the areas containing the predetermined flexion parts and the surroundings. Conversely, the flexible film member may be reduced in thickness only in the portion between the metal wires or both of this porion and the previously mentioned portions may be reduced in thickness. In this case, it is particularly effective to reduce the thickness of the flexible film member in the portions just below the metal wires in terms of flexing characteristic.

Then, while there is no particular limitation to the method of manufacturing a chip carrier according to the present invention, the chip carrier can be manufactured by using for example the following method.

First, a film of metal (e.g., copper, chromium or nickel) having a thickness of 0.1 to 1μm is directly formed by a sputtering evaporation process on the surface of a flexible film member of 10 to 200μm. The film member is made of a material having excellent heat resisting properties, such as, polyimide, polyphenylene sulfide, polyethylene terephthalate or liquid crystal polymer.

Then, metal wires are formed by further applying, in case of need, copper plating onto the metal film to form a metal foil layer of 1 to 35μm thick composed mainly of cooper (any other metal than cooper may be used) and etching the metal foil layer. Alternatively, after the metal film has been formed, copper plating is applied to the metal film while masking the undesired portion (the masking is effected with a negative pattern) and then the metal film on the undesired portion is removed by flush etching, thereby forming metal wires.

Thereafter, the flexible film member is locally reduced in thickness from the back side with respect to part or the whole of the areas containing the predetermined flexion parts of the flexible film member and their surroundings.

The local reduction of the flexible film member in thickness can be effected by using for example a plasma etching process. This process reduces the film thickness of the flexible film by spraying a gas plasma activated by an ECR plasma or the like to the surface to be etched. Also, where the flexible film is a polyimide film, the desirable results can be obtained by wet etching using a mixed solution of hydrazine and ethylenediamine, a solution prepared by mixing an alkaline chemical such as potassium hydroxide with water.

With the chip carrier of the invention produced in the above-mentioned manner, the flexible film is locally reduced in thickness in the portions corresponding to the predetermined flexion parts in superposition relation with the metal wires so that when connecting the metal wires between a pair of objects such as a liquid display device and its circuit board, the metal wires can be bent easily, along with the flexible film, into any desired shape and the chip carrier has an increased resistance to bending fatigue.

In other words, the chip carrier according to the present invention is capable of being bent easily into any desired shape at given places with the metal wires formed thereon, has less danger of the metal wires and the flexible film being damaged, and is excellent in connection working properties.

This type of chip carrier includes a plurality of predetermined mounting areas for semiconductor chips to be mounted and is used effectively for connecting for example a three-dimensionally arranged external unit and each semiconductor chip of a limited connecting pad spacing.

The above and other objects, features and advantages of the present invention will become more apparent from the following description of its embodiments taken in conjunction with the accompanying drawings.

## BRIEF DESCRIPTION OF THE DRAWINGS

Fig. 1 is a partial plan view of a chip carrier according to an embodiment of the present invention.

Fig. 2 is a sectional view taken along the line A-A of the chip carrier shown in Fig. 1.

Fig. 3 is a side view showing schematically an example of a manner in which the chip carrier shown in Fig. 1 is connected to an external circuit device.

## DESCRIPTION OF THE PREFERRED EMBODIMENTS

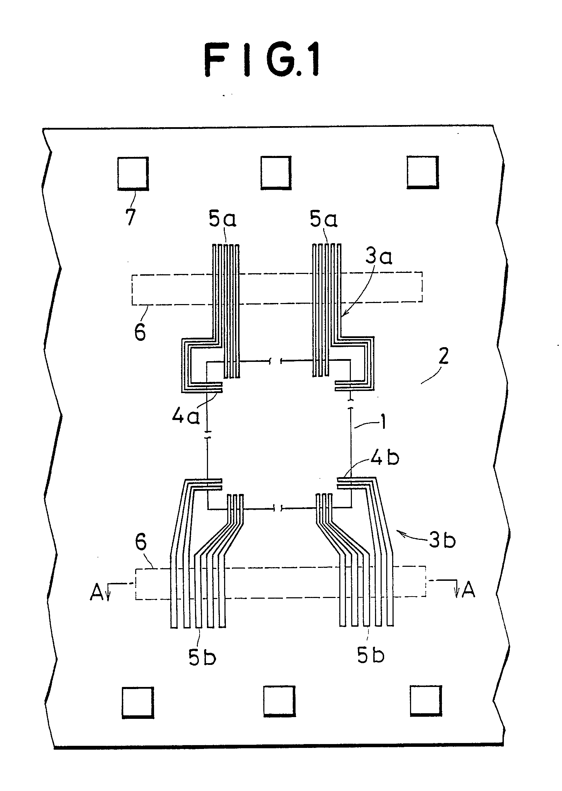

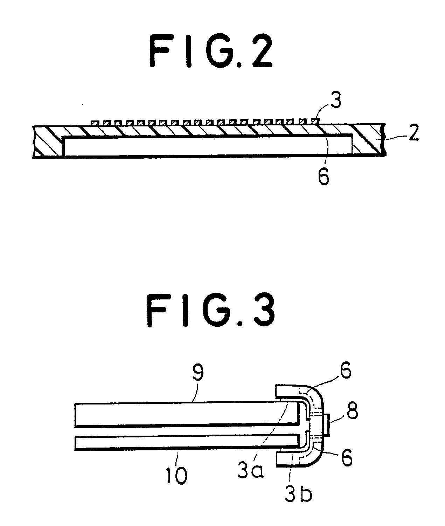

An embodiment of the present invention will now be described with reference to the drawings. The embodiment of the chip carrier shown in Figs. 1 and 2 is in the form of a tape carrier of a two-layer structure.

This tape carrier is manufactured by the following method.

First, a copper film of $0.2\mu m$ is deposited by a sputtering evaporation process on one side of a tape-like flexible film 2 composed of a polyimide film of $50\mu m$ thick and then the copper film is subjected to electroplating thereby forming a copper foil layer of $10\mu m$ thick.

Then, the copper foil is etched using a ferric chloride solution thereby forming metal wires 3a and 3b as shown in Fig. 1.

In this embodiment, the metal wires 3 are formed in such a manner that arranged on both side of the center line (not shown) of the tape are metal wires 3a which are to be connected a liquid crystal device (described later) and metal wires 3b which are to be connected to a circuit board (described later) so as to oppose each other, and the pitch of outer leads 5a (to be connected to the liquid crystal device) of the metal wires 3a is selected smaller than the pitch of outer leads 5b (to be connected to the circuit board) of the metal wires 3b.

It is to be noted that while, in this embodiment, the metal wires are formed so that there is one-to-one correspondence between the inner leads 4a and 4b and the outer leads 5a and 5b, the metal wires of the present invention need not always be formed in these shapes. In other words, the metal wires of the present invention need not always be formed in a manner that each metal wire has the inner lead at one end and the outer lead at the other end. Thus, there are instances where there exists one-to-plural correspondence between the outer leads and the inner leads, where the inner leads are connected to a signal processing circuit or the like formed on the film 2 and so on. Also, while, in this embodiment, each metal wire is formed with the single inner lead which is bonded to the connecting pad of a semiconductor chip, each of the metal wires may be formed with a plurality of inner leads depending on the circumstances.

Then, excluding the back side of the areas containing the predetermined flexion parts in superposition relation with the metal wires 3a and 3b on the flexible film 2 (the hatched area in Fig. 1) and the both sides of the portions corresponding to a device hole 1 and sprocket holes 7, the remaining portion of the flexible film 2 is coated with an alkali-proof etching resist and the whole film 2 is immersed in a 5-normality potassium hydroxide solution for 1 hour for etching.

As a result, the thickness of the polyimide film is reduced to $10\mu m$ in the remaining portion which was not protected by the etching resist. When this occurs, the thickness of the flexible film 2 is locally reduced from the back side in the predetermined flexion parts in superposition relation with the metal wires 3a and 3b and thus slit-like thin-section parts 6 are formed as shown in Fig. 2.

Thereafter, the thin-section parts 6 are also coated with the etching resist and the etching is effected further for 30 minutes under the same conditions as mentioned previously. Thus, a device hole 1 located on substantially the center line and serving as a predetermined mounting place for a semiconductor chip and a plurality of sprocket holes 7 arranged along each lateral portion of the tape for engagement with a tape feeding sprocket are formed thereby producing a tape carrier as shown in Fig. 1.

With the tape carrier manufacture in this way, after a semiconductor chip 8 has been arranged in the device hole 1 and the inner leads 4a and 4b are bonded to the respective terminals of the semiconductor chip 8, the tape carrier is cut to a given shape thereby producing an elemental semiconductor device in which the semiconductor chip 8 is mounted on the film chip carrier.

This elemental semiconductor device is connected to and serves as a hinge of a display device, e.g., a liquid crystal display 9 and a circuit board 10 as shown in Fig. 3. In this case, the outer leads 5a of the metal wires 3a are connected to the terminals of an electrode board of the liquid crystal device 9 and the outer leads 5b of the metal wires 3b are connected to the circuit board 10 whereby the chip carrier is bent at the slit-like thin-section parts 6 along with the metal wires 3a and 3b, thereby arranging the liquid crystal device 9 and the circuit board 10 one upon another.

From the foregoing description it will be seen that in accordance with the present invention the chip carrier is formed with the thin-section parts 6 with the result that the chip carrier can be easily bent and folded back and also there is no danger of the metal wires 3a and 3b being broken even if the chip carrier is repeatedly bent as many as several ten times, thus proving its excellent flexing characteristic.

Also, when the tape carrier is fed by the rotary sprockets at the sprocket holes 7, the tape carrier has no danger of breaking the flexible film member within the range of the ordinary variations of tension.

Further, while, in the present embodiment, there are provided the device holes 1 which are each enclosed by the forward ends of the inner leads 4a and 4b, the device holes 1 are not always needed and depending on circumstances semiconductor chips may be directly mounted on the metal wire-side film surface without forming any device holes.

Still further, as regards the sprocket holes 7 formed in succession at a given pitch longitudinally along each of the left and right sides of the tape, the sprocket holes 7 need not be formed in cases where the tape feed can be effected without using them.

Still further, it is needless to say that the chip carrier of the present invention can be used not only in cases where it is used to hingedly connect separate external units which are arranged one upon another as shown in Fig. 3 but also in cases where it is used to simply mount a semiconductor chip on the flat portion of the surface of each circuit board.

It is to be noted that while the above mentioned embodiment shows the case in which the single semiconductor device using the chip carrier according to the invention is applied to a liquid crystal display unit, it is needless to say that the semiconductor device is equally applicable to other display units such as a plasma display unit and an electroluminescent display unit.

## Claims

1. In a chip carrier including an electrically insulating flexible film member (2), and at least plurality of groups of metal wires (3) formed on a surface of said flexible film member, the improvement wherein a plurality of predetermined flexion parts are each formed in a portion of said flexible film member which is in superposition relation with corresponding ones of said metal wires, and wherein said flexible film member is partly or wholly reduced in thickness in an area thereof containing each said predetermined flexion part as compared with the remaining portion thereof.

2. A chip carrier according to claim 1, wherein said metal wires (3) are formed on either one of two surfaces of said flexible film member (2), and wherein each of said areas containing each said predetermined flexion part is located at a position on another one of the surfaces of said flexible film member, said metal wires being nonexistent at said position, whereby said flexible film member is formed with a thin-section part (6) on said another one of the surfaces at each said position.

3. A chip carrier according to claim 1, wherein said flexible film member includes a slit-like thin-section part (6) along each of said predetermined flexion part.

4. A chip carrier according to claim 1, wherein the thickness of each said thin-section part (6) is 1 2 or less of the thickness of said remaining portion of said flexible film member (2) and not less than 5 μm.

5. A chip carrier according to claim 1, wherein said flexible film member (2) includes at least one predetermined mounting place (1) for a semiconductor chip (8) to be mounted, and wherein at least a pair of said predetermined flexion parts are respectively arrange on both sides of said predetermined mounting place.

6. A chip carrier according to claim 1, wherein said flexible film member (2) is reduced in thickness in said portion thereof just below said metal wires (3) in superposition relation with each said predetermined flexion part as compared with said remaining portion thereof.

7. A chip carrier according to claim 1, wherein said flexible film member (2) is reduced in thickness in a portion thereof lying between said metal wires (3) in superposition relation with said predetermined flexion parts as compared with said remaining portion thereof.

8. A chip carrier according to claim 1, wherein said flexible film member (2) is reduced in thickness in said portion thereof just below said metal wires (3) in superposition relation with each said predetermined flexing part and in a portion thereof lying between said metal wires in superposition relation with said predetermined flexion parts.

9. A combination of a chip carrier according to claim 1, a semiconductor device chip (8) and a display device, wherein said semiconductor device chip is mounted on said chip carrier, and wherein said semiconductor device chip and said display unit are electrically interconnected through said metal wires (3) of said chip carrier, whereby said combination forms a display unit.

10. A combination according to claim 9, wherein said display device includes a liquid crystal panel.

# F I G.1

# FIG.2

3

2

6

# FIG.3

9

6

8

6

10

3a

3b